# FASCICULE DE BREVET EUROPEEN

(11) **EP 3 168 946 B1**
(45) Date de publication et mention de la délivrance du brevet: **28.08.2019**
(21) Numéro de dépôt: 16197424.1
(22) Date de dépôt: 04.11.2016
(51) Int. Cl.: H01S 5/12, H01S 5/02, H01S 5/125, H01S 5/10, H01S 5/20, H01S 5/06, H01S 5/0625, H01S 5/323, H01S 5/065, H01S 5/343

(54) **DISPOSITIF LASER ET PROCÉDÉ DE FABRICATION D'UN TEL DISPOSITIF LASER**
LASERVORRICHTUNG UND HERSTELLUNGSVERFAHREN EINER SOLCHEN LASERVORRICHTUNG
LASER DEVICE AND METHOD FOR MANUFACTURING SUCH A LASER DEVICE

(30) Priorité: 13.11.2015 FR 1560911
(43) Date de publication de la demande: 17.05.2017
(73) Titulaire: Commissariat à l'Énergie Atomique et aux Énergies Alternatives, 75015 Paris (FR); STmicroelectronics SA, 92120 Montrouge (FR); STMicroelectronics (Crolles 2) SAS, 38920 Crolles (FR)
(72) Inventeur: FERROTTI, Thomas, 88650 ENTRE-DEUX-EAUX (FR); BEN BAKIR, Badhise, 38590 BREZINS (FR); CHANTRE, Alain, 38180 SEYSSINS (FR); CREMER, Sébastien, 38000 GRENOBLE (FR); DUPREZ, Hélène, 38170 SEYSSINET-PARISET (FR)
(74) Mandataire: GIE Innovation Competence Group

(56) Documents cités:
- JP-A- 2013 140 834
- US-A1- 2011 299 561
- A. DESCOS ET AL: "Heterogeneously Integrated III-V/Si Distributed Bragg Reflector Laser with Adiabatic Coupling", 39TH EUROPEAN CONFERENCE AND EXHIBITION ON OPTICAL COMMUNICATION (ECOC 2013), 1 janvier 2013 (2013-01-01), pages 687-689, XP055197576, DOI: 10.1049/cp.2013.1502 ISBN: 978-1-84-919759-5

## Description

### DOMAINE TECHNIQUE

La présente invention se rapporte au domaine des composants photoniques intégrés qui utilisent à la fois les propriétés des matériaux semi-conducteurs aptes à émettre de la lumière et celles des matériaux semi-conducteurs utilisés classiquement dans les circuits intégrés.

Plus particulièrement, la présente invention concerne un dispositif laser et un procédé de fabrication d'un tel dispositif laser.

Un tel dispositif laser peut être employé pour réaliser des liaisons optiques à grandes vitesses, des liaisons intrapuces, intracartes, en espace libre.

### ÉTAT DE LA TECHNIQUE ANTÉRIEURE

Un aspect important de la photonique en silicium est l'accordabilité des lasers à semi-conducteur en longueur d'onde, notamment dans leur application dans les télécommunications dans des réseaux à multiplexage en longueur d'onde.

Différentes solutions ont été proposées parmi lesquelles l'utilisation d'un laser DBR (pour « Distributed Bragg Reflector » à savoir un laser à réflecteurs de Bragg distribués).

En effet, en plaçant un élément chauffant à proximité des réseaux de Bragg et en augmentant de façon précise la température au niveau des réseaux de Bragg par l'application d'un courant aux éléments chauffants, l'indice de réfraction du silicium est modifié par la variation de température, ce qui permet donc de modifier la longueur d'onde de sortie d'un tel laser dans une certaine plage de longueur d'onde.

Cependant, la plage d'accordabilité est souvent limitée à moins de 20nm, ce qui est trop limité. De plus, on ne peut modifier la longueur d'onde de sortie que vers les longueurs d'ondes plus élevées (vers le rouge), et non dans l'autre sens. De plus la dissipation thermique des éléments de chauffage est également un problème en termes de vieillissement du laser et de consommation de puissance électrique.

Pour surmonter ces problèmes, il a été proposé d'équiper des lasers DBR de réseaux de Bragg échantillonnés que l'on appelle SG-DBR (pour « Sampled Grating - Distributed Bragg Reflector » en anglais à savoir un réflecteur de Bragg distribué et à réseau échantillonné en français).

Dans un réseau de Bragg échantillonné, on superpose à un premier réseau de Bragg un second réseau ayant un pas plus important que le premier réseau.

Dans ce cas, le pas du premier réseau de Bragg définit la longueur d'onde de sortie centrale, tandis que le pas du second réseau de Bragg ajoute des pics de réflexion supplémentaires.

Si un pic de réflexion du premier réseau est en coïncidence avec un pic de réflexion du second réseau, on obtiendra le seuil le plus faible ce qui va donc définir la fréquence d'oscillation du laser.

Dans un laser SG-DBR, si on change l'indice de réfraction ou le pas d'un des réseaux de Bragg échantillonné, par exemple par application d'un courant pour l'échauffement, on peut, par effet Vernier, faire sauter la coïncidence sur un des pics de réflexion suivants ce qui permet une accordabilité par sauts dans une large gamme de longueurs d'onde, ceci dans les deux directions, c'est-à-dire des fréquences plus faibles ou les fréquences plus élevées. En changeant l'indice de réfraction par exemple par effet thermodynamique des deux réseaux de Bragg échantillonnés simultanément, on obtient une accordabilité fine en continue. L'accordabilité de ce type de laser couvre une plage de plus de 100nm, ce qui fait que ce type de laser présente un intérêt particulier dans le domaine des télécommunications, notamment pour la technologie WDM de multiplexage en longueur d'onde.

Cependant, dans les lasers SG-DBR connus de l'état de la technique, le premier réseau et le second réseau d'un réflecteur de Bragg échantillonné sont réalisés par superposition sur la même face dans une couche semi-conductrice, ce qui impose des contraintes dans la réalisation et limite les degrés de liberté dans la conception. De plus, cela impose généralement des réflecteurs de Bragg échantillonnés plus longs et encombrants afin d'obtenir une efficacité élevée en particulier du second réseau à pas plus long que le premier réseau.

La présente invention vise à pallier, au moins partiellement, les inconvénients précités en proposant un dispositif laser permettant une plus grande liberté de conception et un encombrement plus faible tout en présentant une réflectivité importante par unité de longueur.

A cet effet, la présente invention propose un dispositif laser comme il est défini par la revendication 1.

En particulier en dé-corrélant physiquement les deux réseaux d'un ensemble de réseaux de Bragg, on peut découpler la sélectivité en longueur par effet Vernier. De plus, en ce qui concerne la réflectivité des deux réseaux de Bragg, on obtient une réflectivité accrue et donc un réflecteur de Bragg plus efficace. Ceci permet de réaliser des lasers DBR plus courts et moins encombrants que les lasers SG-DBR connus tout en leur étant semblables en fonctionnement.

Le dispositif laser peut selon l'invention comporter un ou plusieurs des aspects suivants pris seuls ou en combinaison :
Selon un aspect, le guide d'onde optique en arête est orienté de manière à ce que l'arête soit disposée sur la face du guide d'onde en ruban qui est distale par rapport au milieu amplificateur.

Selon un autre aspect, le premier pas des premiers réseaux de Bragg formés, notamment gravés, dans l'arête est plus grand que le second pas du second réseau formé, notamment gravé, sur la face du guide d'onde en ruban opposée à l'arête.

L'un des ensembles de réseaux de Bragg possède par exemple une longueur comprise entre 700µm et 1000µm, limites incluses et une réflectivité supérieure à 90% et l'autre ensemble de réseaux de Bragg possède une longueur comprise entre 300µm et 600µm, limites incluses et une réflectivité comprise entre 30% et 80% limites incluses.

Selon encore un autre aspect, les premiers réseaux de Bragg sont formés par des portions rétrécies et des portions plus larges de l'arête.

La largeur de l'arête au niveau des portions rétrécies peut être comprise entre 0% - 80% de la largueur des portions plus larges de l'arête.

Selon encore un autre aspect, les seconds réseaux de Bragg sont uniquement formés, notamment gravés, au niveau des premiers réseaux de Bragg à l'emplacement des portions plus larges de l'arête.

Selon une alternative, les seconds réseaux de Bragg sont uniquement formés, notamment gravés, au niveau des premiers réseaux de Bragg à l'emplacement des portions rétrécies de l'arête.

Par ailleurs, la transition entre les portions rétrécies et les parties élargies définit des flancs de transition orientés par exemple perpendiculairement par rapport à la direction de propagation de la lumière.

En variante, la transition entre les portions rétrécies et les parties élargies définit des flancs de transition qui sont inclinés par rapport à une direction perpendiculaire à la direction de propagation de la lumière.

La profondeur de gravure des deux réseaux d'un ensemble de réseaux de Bragg peut être différente.

En particulier, la profondeur de gravure des premiers réseaux est plus importante que la profondeur de gravure des seconds réseaux.

La largeur des seconds réseaux des ensembles de réseaux de Bragg est par exemple supérieure à celle de l'arête.

On peut prévoir que la largueur des seconds réseaux des ensembles de réseaux de Bragg est sensiblement égale à la largeur du guide d'onde en ruban.

Selon encore un autre aspect, le guide d'onde en ruban et l'arête longitudinale sont chacun formés de silicium cristallin ou l'un en silicium cristallin et l'autre en silicium amorphe.

L'arête longitudinale est par exemple en silicium cristallin et le guide d'onde en ruban est par exemple formé par deux couches dont celle en contact avec l'arête longitudinale également en silicium cristallin et dont l'autre proximale au milieu amplificateur en silicium amorphe.

L'invention concerne également un procédé de fabrication d'un dispositif laser comme défini dans la revendication 17.

### DESCRIPTION SOMMAIRE DES DESSINS

D'autres avantages et caractéristiques apparaîtront à la lecture de la description de l'invention, ainsi que des figures suivantes sur lesquelles :
- la figure 1 montre un premier mode de réalisation d'un dispositif laser selon l'invention selon une vue schématique en coupe longitudinale,
- la figure 2 montre le dispositif laser de la figure 1 selon une vue schématique en coupe transversale selon la ligne de coupe II-II de la figure 1,
- la figure 3A montre une représentation schématique en perspective du guide d'onde en arête du dispositif laser de la figure 1,
- la figure 3B montre une représentation schématique en coupe longitudinale du guide d'onde en arête du dispositif laser de la figure 1,
- la figure 3C montre une représentation schématique en vue de dessous du guide d'onde en arête du dispositif laser de la figure 1,
- la figure 4 montre une vue partielle de dessus du dispositif laser de la figure 1,
- la figure 5 montre une vue partielle de dessus d'un second mode de réalisation du dispositif laser selon l'invention,
- la figure 6 montre une vue partielle de dessus d'un troisième mode de réalisation du dispositif laser selon l'invention,
- la figure 7 montre une vue partielle de dessus d'un quatrième mode de réalisation du dispositif laser selon l'invention,
- la figure 8A montre un cinquième mode de réalisation d'un dispositif laser selon l'invention selon une vue schématique en coupe longitudinale,
- la figure 8B montre une vue partielle de dessus du cinquième mode de réalisation du dispositif laser selon l'invention,
- les figures 9A, 10A/10B à 18A/18B montrent des vues schématiques en coupe pour illustrer un procédé de fabrication d'un dispositif laser selon l'invention, les figures « A » étant des vues schématiques en coupe longitudinale tandis que les figures « B » sont des vues correspondantes en coupe transversale.

### DESCRIPTION DE MODES DE RÉALISATION

Sur toutes les figures, les éléments identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations.

Dans la description, on peut indexer certains éléments ou paramètres, comme par exemple premier élément ou second élément ainsi que premier paramètre et second paramètre ou encore premier critère et second critère etc. Dans ce cas, il s'agit d'un simple indexage pour différencier et dénommer des éléments ou paramètres ou critères proches mais non identiques. Cette indexation n'implique pas une priorité d'un élément, paramètre ou critère par rapport à un autre et on peut aisément interchanger de telles dénominations sans sortir du cadre de la présente description.

Dans le présent exposé, le terme « longitudinal » doit être compris sensiblement parallèlement au sens de propagation de la lumière (voir flèche F1) et le terme « transversal » doit être compris sensiblement transversalement au sens de propagation de la lumière.

Par « pas d'un réseau de Bragg », on entend la longueur d'une période du réseau de Bragg. Par « pic d'un réseau de Bragg » ou « pic de réflexion » on entend une plage spectrale, généralement réduite, où la réflectivité du réseau de Bragg est suffisamment haute pour permettre une utilisation en tant que réflecteur extrémal de cavité optique, en particulier dans le cadre d'un laser.

Quand on indique une plage de longueurs d'onde « limites incluses », cela veut dire que les valeurs limites déterminant la plage de longueur d'onde font également partie de cette plage. Ainsi, pour une plage de longueurs d'onde entre 500nm et 600nm limites incluses, les valeurs de 500nm et 600nm font également partie de la plage de longueurs d'onde.

Par convention, sur un circuit optique réalisé dans un plan donné, il est défini des états de polarisation TE (pour "transverse electric" en anglais) et TM (pour "transverse magnetic" en anglais) tels que dans l'état TE le champ électrique est parallèle au plan du circuit, alors que le champ magnétique est perpendiculaire au plan du circuit, et dans l'état TM le champ magnétique est parallèle au plan du circuit tandis que le champ électrique est perpendiculaire au plan du circuit. En fait, dans le laser il faudra implicitement considérer un état de polarisation quasi-TE, c'est à dire que le champ électrique est très majoritairement polarisé selon sa direction TE. Ainsi, la structure du laser telle que décrite permettra préférentiellement un couplage du mode TE ou quasi-TE de l'onde.

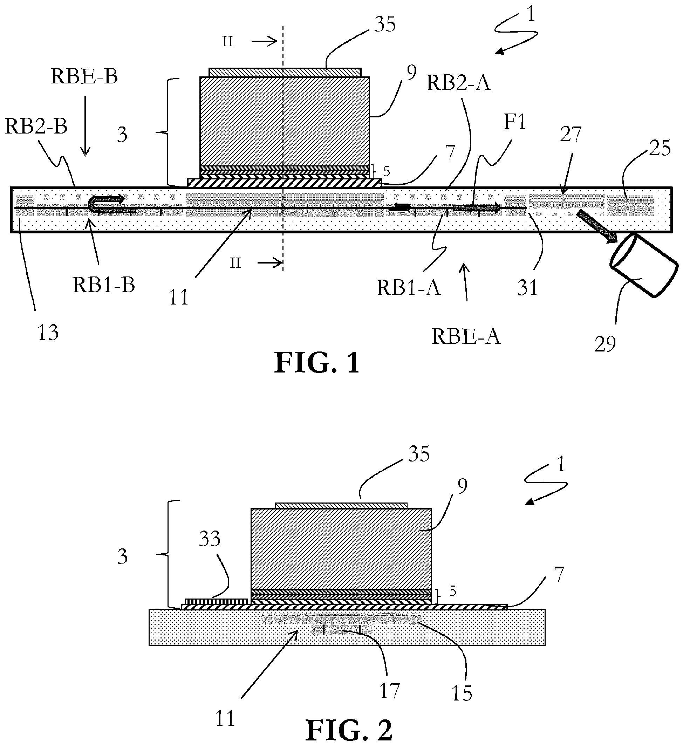

Les figures 1 à 4 présentent un premier mode de réalisation d'un dispositif laser 1 selon l'invention. Dans ce mode de réalisation, il s'agit d'un dispositif laser DBR (pour « Distributed Bragg Reflector » en anglais à savoir un laser à réflecteurs de Bragg distribués en français) intégré sur silicium et à hétéro structure III-V dopée.

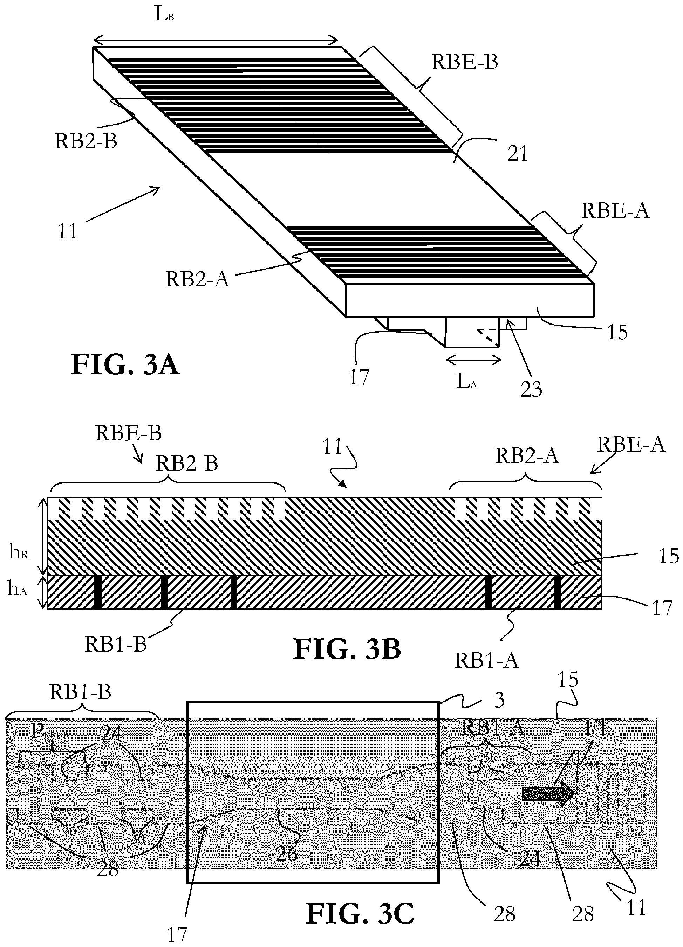

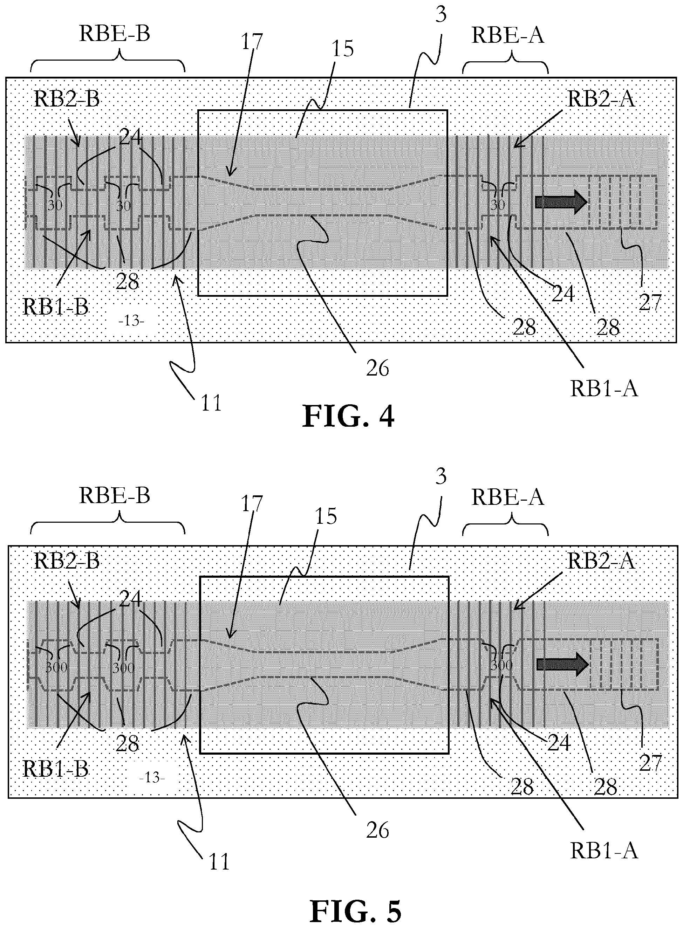

La figure 1 est une vue schématique en coupe longitudinale, la figure 2 une vue en coupe transversale selon la ligne de coupe II-II de la figure 1. La figure 3A montre une représentation schématique en perspective du guide d'onde en arête du dispositif laser de la figure 1. La figure 3B montre une représentation schématique en coupe longitudinale du guide d'onde en arête du dispositif laser 1 de la figure 1. La figure 3C montre une représentation schématique en vue de dessous du guide d'onde en arête du dispositif laser 1 de la figure 1, et la figure 4 montre une vue partielle de dessus du dispositif laser 1.

Le dispositif laser 1 comporte un milieu amplificateur optique 3 à hétérostructure de type III-V, l'hétérostructure étant agencée pour générer des photons, autrement dit une onde optique.

Par hétérostructure de type III- V, on entend l'utilisation de matériaux pouvant être choisis dans la liste non exhaustive suivante : InP, GaAs, InGaAlAs, InGaAsP, AlGaAs, InAsP. L'hétérostructure d'un tel milieu amplificateur 3, aussi appelé milieu à gain, peut comporter un empilement de diverses couches, comme par exemple un empilement de couches 5 formant des puits quantiques prises en sandwich entre une première couche 7 dopée, de préférence dopée N, et une seconde couche 9 dopée, de préférence dopée P.

Typiquement la couche 9 sera dopée P dans les 10¹⁹ cm³ et la couche 7 dopée N dans les 10¹⁸ cm³. Plus précisément, les couches 7 et 9 peuvent elles-mêmes être formées par épitaxie et être composées de plusieurs sous-couches, à dopage variable (le dopage diminue lorsque l'on se rapproche des puits quantiques). Les puits quantiques ne sont pas dopés.

La première couche 7 dopée, lorsqu'elle est dopée N, peut comporter un matériau choisi, pour l'essentiel, parmi InP, GaAs, InGaAsP, InGaAIAs, AIGaAs, InAsP. La seconde couche 9 dopée, lorsqu'elle est dopée P, peut comporter un matériau choisi parmi InP, GaAs, InGaAsP, InGaAIAs. Autrement dit, les matériaux utilisés pour la première couche 7 et la seconde couche 9 peuvent être les mêmes, seul le dopage change.

Bien entendu, le dopage peut être inversé, c'est-à-dire que la première couche 7 dopée peut être dopée P, et la seconde couche 9 dopée peut être dopée N. L'empilement de couches 5 peut comporter des puits quantiques ou des boîtes quantiques permettant la recombinaison de trous et d'électrons pour former des photons, et ainsi générer l'onde optique au niveau du milieu amplificateur 3. Les éléments (puits ou boîtes) quantiques peuvent comporter un matériau tels que InP, GaAs, InGaAsP, InGaAlAs, AlGa, As, InAsP.

L'épaisseur du milieu amplificateur à hétéro-structure 3 est typiquement de l'ordre de plusieurs microns.

L'épaisseur de l'empilement de puits quantiques 5 est de l'ordre de 200-400nm, par exemple de 300 nm et l'épaisseur de la couche 7 est de l'ordre de 100-200nm. La couche 9 peut avoir une épaisseur comprise entre 1-3µm.

Comme cela est représenté sur les figures 1 et 2, sous le milieu amplificateur 3 est disposé un guide d'onde optique en arête 11 intégré ou formé dans une couche de silicium sur isolant 13 (SOI en anglais pour « silicon on insulator »).

Ce guide d'onde en arête 11 est disposé en regard du milieu amplificateur 3 et se compose d'un guide d'onde en ruban 15 doté d'une arête longitudinale 17 (voir figures 2 et 3A). Le guide d'onde en ruban 15 et l'arête longitudinale 17 sont par exemple formés de silicium cristallin tous les deux.

Cependant d'autres options sont possibles. On note en particulier un premier cas où le guide d'onde en ruban 15 est en silicium cristallin et l'arête longitudinale 17 est en silicium amorphe.

Selon un second cas particulièrement intéressant, l'arête longitudinale 17 est en silicium cristallin et le guide d'onde en ruban 15 est formé par deux couches dont celle en contact avec l'arête longitudinale 17 également en silicium cristallin et dont l'autre proximale au milieu amplificateur 3 en silicium amorphe, c'est-à-dire la couche qui est au plus près du milieu amplificateur 3. L'arête longitudinale 17 et la couche en silicium cristallin du guide d'onde en ruban 15 sont dans la couche 13 de silicium sur isolant (SOI) tandis que la couche en silicium amorphe se trouve dans une couche isolante au-dessus de la couche de silicium sur isolant. Cet arrangement permet de garder une compatibilité maximale avec des processus et dispositifs photoniques silicium en face avant existants et de minimiser le budget thermique appliqué à la couche de silicium amorphe.

Vu en coupe (Fig. 2), le guide d'onde en ruban 15 et l'arête longitudinale 17 sont rectangulaires tous les deux, mais leur largeur, notamment de l'arête 17 peut varier dans le sens de propagation de la lumière (exemple en Fig. 3C et 4).

Plus spécifiquement, le guide d'onde optique en arête 11 est orienté de manière à ce que l'arête 17 soit disposée sur la face 23 du guide d'onde en ruban 15 qui est distale par rapport au milieu amplificateur 3.

Le dispositif laser 1 comprend deux ensembles de réseaux de Bragg RBE-A et RBE-B disposés de part et d'autre par rapport au milieu amplificateur 3 à hétérostructure III-V.

Chaque ensemble de réseaux de Bragg RBE-A, RBE-B comprend un premier réseau de Bragg RB1-A respectivement RB1-B présentant un premier pas et réalisé par exemple par gravure dans l'arête 17 du guide d'onde optique en arête 11 ainsi qu'un second réseau de Bragg RB2-A respectivement RB2-B, réalisé sous forme de réseau de Bragg présentant un second pas, différent du premier pas, et réalisé par gravure sur la face 21 du guide d'onde en ruban 15 opposé à l'arête 17. En particulier, le pas du premier réseau de Bragg RB1-A et RB1-B gravé dans l'arête 17 est plus grand que le pas du second réseau RB2-A et RB2-B gravé sur la face 21 du guide d'onde en ruban 15 opposée à l'arête. L'indice effectif dans le cas d'un réseau en silicium et pour des longueurs d'onde télécom est compris entre 3.3 et 3.7. Les pas des réseaux RB2-A et RB2-B sont tous deux égaux à une valeur comprise entre 150 et 300nm (compris entre λ/7 ou λ/6). Les pas des réseaux RB1-A & RB1-B ne sont pas égaux. Ils sont tels qu'une différence de leurs premiers pics est de l'ordre du nm (abs(Δλ1 - Δλ2)) ≈ 1nm, Δλ1 étant la différence des premiers pics de RB1-A et Δλ2 la différence des pics de RB1-B. Ces différences des premiers pics Δλ1 et Δλ2 sont typiquement compris entre 5nm et 20nm. Il en résulte une plage de pas pour les réseaux RB1-A, RB1-B allant de 10µm à 40µm. L'indice de groupe n_{g} vaut autour de 4 pour du silicium dans la plage des longueurs d'onde télécom.

Comme on peut le voir en particulier sur la figure 3C, l'arête 17 possède à ses deux extrémités des portions rétrécies 24 et des portions plus larges 28 dans le sens transversal, formant ainsi les premiers réseaux de Bragg RB1-A et RB1-B.

La largeur des portions rétrécies 24 est comprise entre 0% - 80% de la largueur des portions plus larges 28 de l'arête 17 .

Dans ce premier mode de réalisation, la transition entre les portions rétrécies 24 et les parties plus larges 28 définit des flancs de transition 30 orientés perpendiculairement par rapport à la direction de propagation de la lumière F1.

L'ensemble de réseaux de Bragg RBE-B possède une longueur comprise entre 700µm et 1000µm, limites incluses et une réflectivité supérieure à 90% et l'autre ensemble de réseaux de Bragg RBE-A possède une longueur comprise entre 300µm et 600µm, limites incluses et une réflectivité comprise entre 30% et 80% limites incluses. Les longueurs des réseaux RB1-A et RB2-A respectivement RB1-B et RB2-B sont de préférence égales, mais elles peuvent dans certains cas être légèrement différentes, notamment si la longueur n'est pas à la fois un multiple des pas des réseaux RB1-A et RB2-A respectivement RB1-B et RB2-B.

Pour un meilleur couplage, la portion centrale 26 de l'arête 17 qui est située sous le milieu amplificateur 3 possède également une largeur plus faible notamment par rapport aux portions 28, par exemple de même largeur que celle des portions rétrécies 24. La largeur de la portion 26 sera typiquement inférieure à 800nm.

L'arête longitudinale 17 disposée sous le guide d'onde en ruban 15 (comme représenté sur les figures 1 à 4) est distale par rapport au milieu amplificateur 3. Par « distale », on entend ici que l'arête 17 est disposée sur la face 23 opposée à la face 21 : la face 23 est la plus éloignée du milieu amplificateur 3.

Ceci est également bien visible sur la figure 3A montrant le guide d'onde en arête 11 de façon isolée.

Comme on peut le voir sur la figure 3A, la largeur L_{B} des second réseaux de Bragg RB2-A et RB2-B est supérieure à la largeur L_{A} de l'arête 17. En particulier la largeur L_{B} des second réseaux de Bragg RB2-A et RB2-B est égale à la largeur du guide d'onde en ruban 15.

De plus, on peut choisir la largeur L_{B} des réseaux des seconds réseaux de Bragg RB2-A ou RB2-B indépendamment de la largeur L_{A} de l'arête ainsi que des premiers réseaux de Bragg RB1-A et RB1-B, ceci sans influence sur la réflectivité des seconds réseaux de Bragg RB2-A ou RB2-B. La largeur L_{B} des réseaux des seconds réseaux de Bragg RB2-A ou RB2-B est choisie supérieur au um.

La figure 3B montre une vue schématique en coupe longitudinale (dans le sens de propagation de la lumière) du guide en arête 11 avec les ensembles de réseaux de Bragg RBE-A et RBE-B.

La hauteur h_{A} de l'arête 17 est comprise entre 100nm et 250nm, en particulier 200nm.

La hauteur h_{R} du guide en ruban 15 est comprise entre 250nm et 350nm, en particulier 300nm.

On se réfère maintenant à la figure 4 montrant une vue partielle de dessus du dispositif laser de la figure 1.

On y voit en trait plein sous forme de lignes transversales les seconds réseaux de Bragg RB2-A et RB2-B ainsi que sous forme de pointillés la forme de l'arête 17.

La portion centrale 26 de l'arête 17 se trouve sous l'empreinte du milieu amplificateur 3 représenté par un carré.

Vu sur la gauche de la figure 4, on y voit le second réseau de Bragg RB2-B qui est gravé dans la face 21 du guide d'onde en ruban 15.

L'arête 17 est élargie dans cette portion où est localisé le second réseau de Bragg RB2-B et possède les portions rétrécies 24 espacés de façon régulière et formant ainsi par la structuration de l'arête 17 le premier réseau de Bragg RB1-B.

Le premier réseau de Bragg RB1-A ou RB1-B est formé par la périodicité des flancs 30 entre les portions rétrécies 24 et les parties élargies 28. Par exemple une période P_{RB1-B} est définie dans l'un ou l'autre des sens de propagation par la distance entre deux flancs 30 de même transition, par exemple élargie vers étroit ou vice versa.

Sur la figure 4, on a représenté trois portions rétrécies 24 pour former le premier réseau de Bragg RB1-B, mais on peut bien avoir plus de portions rétrécies disposées avec une périodicité différente.

Du fait du pas plus grand du premier réseau RB1-B que celui du second réseau de Bragg RB2-B, on obtient des pics de réflexion supplémentaires pour cet ensemble de réseaux de Bragg RBE-B.

Vu sur la droite de la figure 4, on a une structure similaire avec un ensemble de réseaux de Bragg RBE-A plus court pour la sortie. On y voit le second réseau de Bragg RB2-A qui est gravé dans la face 21 du guide d'onde en ruban 15. L'arête 17 est élargie dans cette portion où est localisé le second réseau de Bragg RB2-A et possède une portion rétrécie 24. Mais on peut bien entendu envisager plus de portions rétrécies 24.

La largeur de l'arête 17 au niveau des portions rétrécies 24 et au niveau de la partie centrale 26 est comprise entre 0.2µm et 0.8µm.

La largeur maximale lₘₐₓ de l'arête 17 est supérieure à L_{A} et inférieure à 3µm

On se réfère maintenant aux figures 1 et 4. Comme on voit sur ces figures, le dispositif laser 1 comporte en outre un réseau de sortie 27.

Ce réseau 27 de couplage avec une fibre optique 29 peut comporter un réseau de tranchées réalisées partiellement dans le guide d'onde 11, par exemple par gravure de ce dernier. De préférence, les tranchées sont sensiblement perpendiculaires à l'axe longitudinal du guide d'onde 11, et sont formées sur une face inférieure du guide d'onde 11, la face inférieure 31 étant sur la figure 1 la face du guide d'onde 11 orientée vers le bas et sensiblement parallèle au plan du guide d'onde 11. Pour le guide d'onde 11 selon les dimensions précitées, les tranchées peuvent avoir une profondeur de 125nm, voire plus si nécessaire. Le réseau peut, par exemple, être défini en utilisant un masque dur, puis une gravure directionnelle.

Par ailleurs, des dépôts eutectiques 33 et 35 (figure 2), respectivement déposés sur la première couche dopée 7 et la seconde couche dopée 9 permettent de prendre des contacts métalliques sur les couches 7 et 9.

Du fait de disposer les premiers RB1-A, RB1-B et seconds RB2-A, RB2-B réseaux des ensembles de réseaux de Bragg RBE-A et RBE-B sur des faces opposées, on gagne en souplesse dans la conception du dispositif laser 1 et on minimise les pertes ce qui permet d'avoir des ensembles de réseaux de Bragg plus courts et de réaliser des dispositifs laser 1 moins encombrants.

Les dispositifs laser 1 ainsi obtenus fonctionnent de façon analogue à un laser SG-DBR connu.

La figure 5 montre selon une vue identique à celle de la figure 4 un deuxième mode de réalisation du dispositif laser 1 selon l'invention.

Ce mode de réalisation se distingue de celui des figures 1 à 4 par le fait que des flancs de transition 300 sont inclinés par rapport à une direction perpendiculaire à la direction de propagation de la lumière, ce qui permet d'assurer un couplage moins abrupt. Dans ce cas de figure les pertes deviennent négligeables.

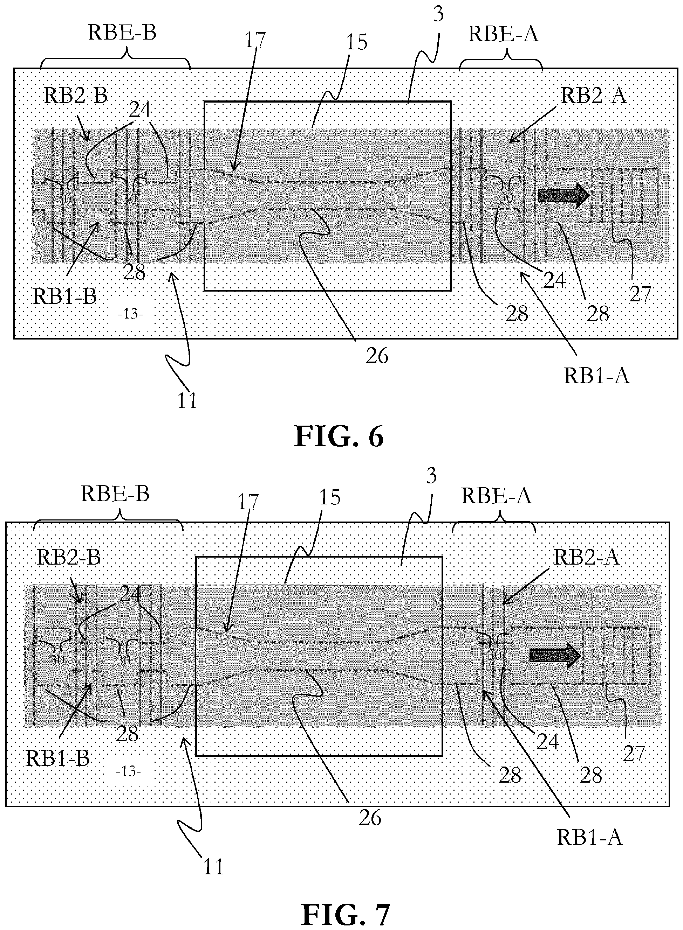

La figure 6 montre un troisième mode de réalisation du dispositif laser 1 selon l'invention, réalisé selon un mode dérivé des réseaux de Bragg dits échantillonnés.

Selon ce mode le second réseau de Bragg RB2-A ou RB2-B est uniquement gravé au niveau du premier réseau de Bragg RB1-A ou RB1-B à l'emplacement des portions plus larges 28 de l'arête 17. On obtient ainsi pour le second réseau RB2-A ou RB2-B un « suréchantillonnage » ou un réseau de Bragg à sauts de phase plus rapprochés et plus nombreux pour une gamme de longueur d'onde considérée, permettant de multiplier d'avantage les pics de réflexion et de donner encore plus de souplesse dans l'accordabilité du dispositif laser 1. Par suréchantillonnage on entend ici à la fois un nombre de pics de réflexion plus grand par domaine de longueur d'onde déterminé (effet Vernier) et/ou un recouvrement plus important des domaines de longueur d'onde utilisables en décalant lesdits pics de réflexion par changement d'indice simultané des deux ensembles de réseaux de Bragg RBE-A, RBE-B.

La figure 7 montre un quatrième mode de réalisation du dispositif laser 1 selon l'invention.

Il s'agit d'une variante de mode de réalisation de la figure 6. Dans ce mode de réalisation le second réseau de Bragg RB2-A ou RB2-B est uniquement gravé au niveau du premier réseau de Bragg RB1-A ou RB1-B, à l'emplacement des portions rétrécies 24 de l'arête 17. Ce mode de réalisation fonctionne de façon similaire à celui de la figure 6.

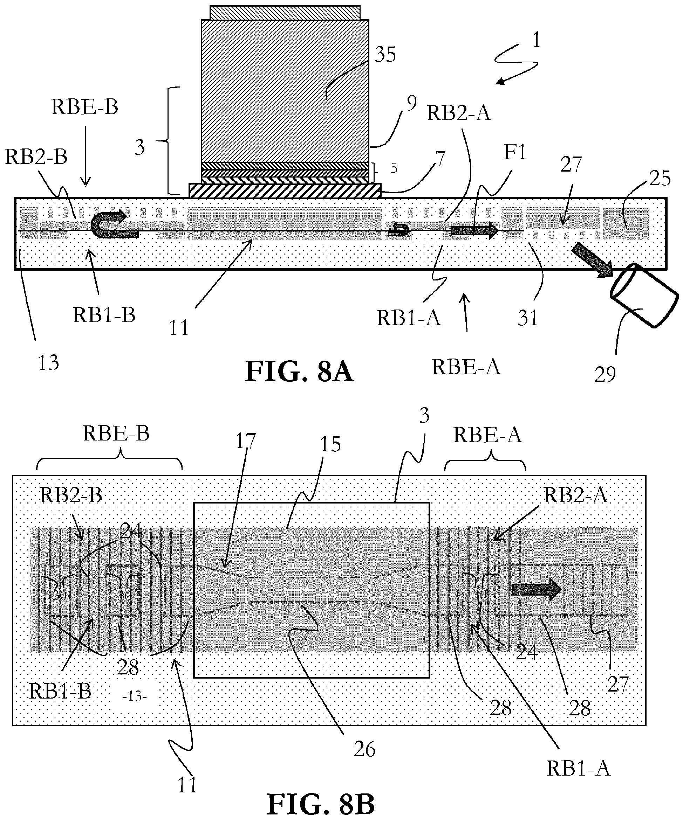

Les figures 8A et 8B montrent un cinquième mode de réalisation du dispositif laser selon l'invention.

Ce mode de réalisation se distingue de celui des figures 1 à 4 par le fait que la largeur de l'arête 17 au niveau des partie rétrécies 24 est égale à zéro. Pour ce faire, on enlève par exemple des portions de l'arête 17 par gravure.

Il en résulte, que la profondeur de gravure des seconds réseaux de Bragg RB2-A et RB2-B d'un côté et des premiers réseaux de Bragg RB1-A et RB1-B de l'autre côté est différente. En particulier la profondeur de gravure du premier réseau RB1-A et RB1-B est plus importante que la profondeur de gravure du second réseau RB2-A et RB2-B, ce qui donne encore plus de liberté dans la conception d'un tel dispositif laser 1 selon l'invention.

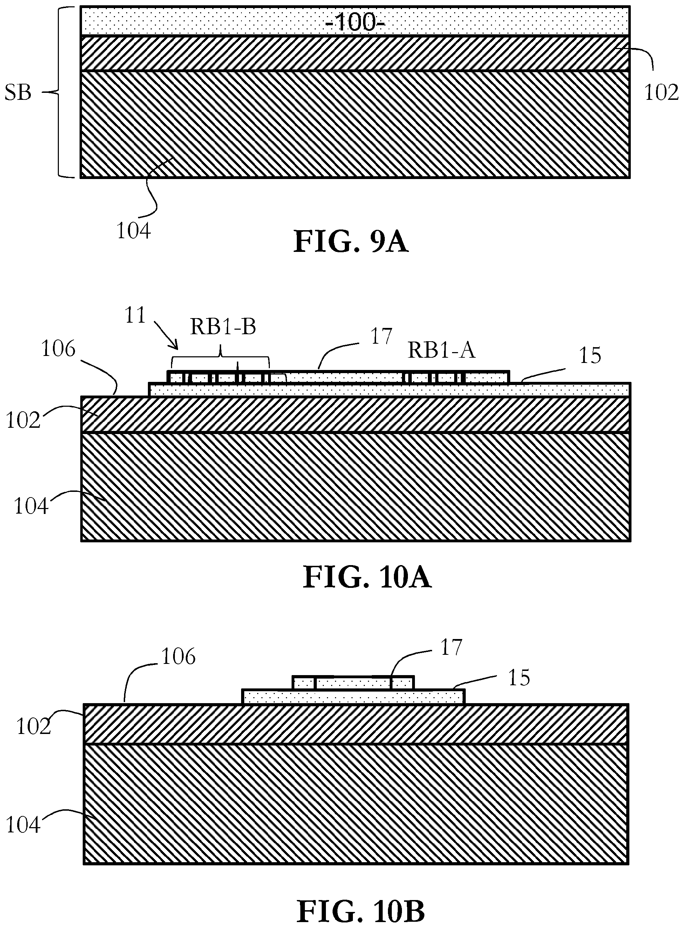

En référence aux figures 9A, 10A/10B à 19A/19B, on va maintenant décrire un procédé de fabrication d'un dispositif laser 1 selon l'invention.

Les figures 9A, 10A/10B à 18A/18B montrent des vues schématiques en coupe, les figures « A » étant des vues schématiques en coupe longitudinale tandis que les figures « B » sont des vues correspondantes en coupe transversale.

Comme on le voit sur la figure 9A, la référence SB désigne un substrat du type Silicium-sur-isolant (SOI : « Silicon-on-Insulator » en anglais) d'une plaquette ou « wafer ».

Ce substrat « SOI » comporte une couche ou film de silicium 100 ayant par exemple une épaisseur comprise entre 200nm et 1µm typiquement de 500nm et disposée au-dessus d'une couche isolante enterrée 102, communément désignée BOX (pour « Buried OXide » en anglais). Cette couche isolante enterrée 102 est elle-même disposée au-dessus d'un substrat de support 104.

Lors d'une première étape visible sur les figures 10A et 10B, on structure la couche de silicium 100, par exemple par gravure, pour obtenir un guide d'onde en arête 11. Si le dispositif laser 1 fait partie d'un ensemble fonctionnel plus important, d'autres composants (modulateurs, photodétecteurs etc) peuvent être réalisés lors de cette étape sur la face supérieure 106 de la couche BOX 102.

Lors de cette étape, on réalise aussi par gravure sur l'arête 11 ou lors de la structuration de la couche de silicium 100 des premiers réseaux de Bragg RB1-A, RB1-B des ensembles de réseaux de Bragg RBE-A, RBE-B.

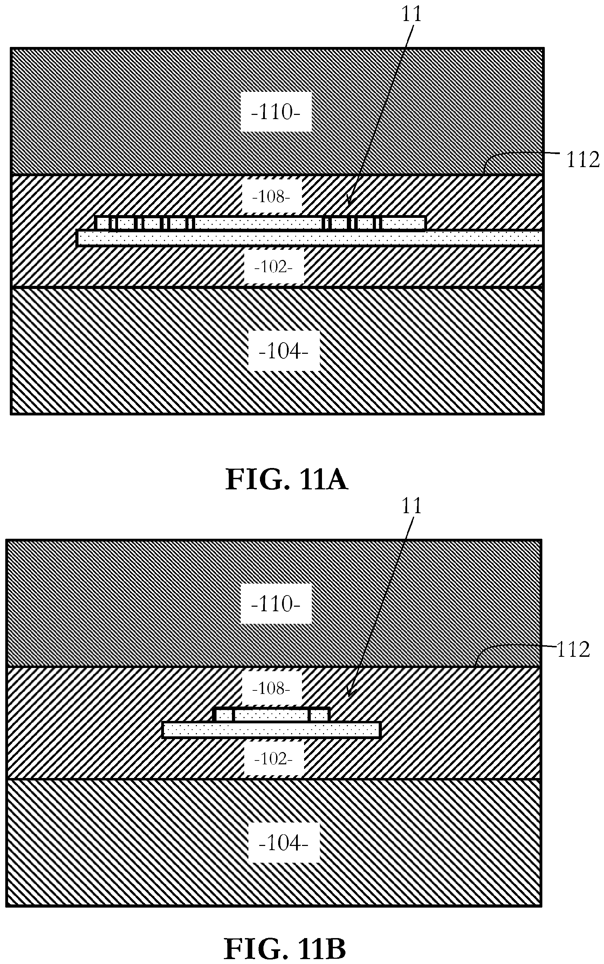

Comme on le voit sur les figures 11A et 11B, une couche d'isolant 108, par exemple du SiO2, est déposée pour encapsuler le guide d'onde en arête 11. Puis un substrat de support 110 est collé sur la face supérieure 112 de la couche isolante 108.

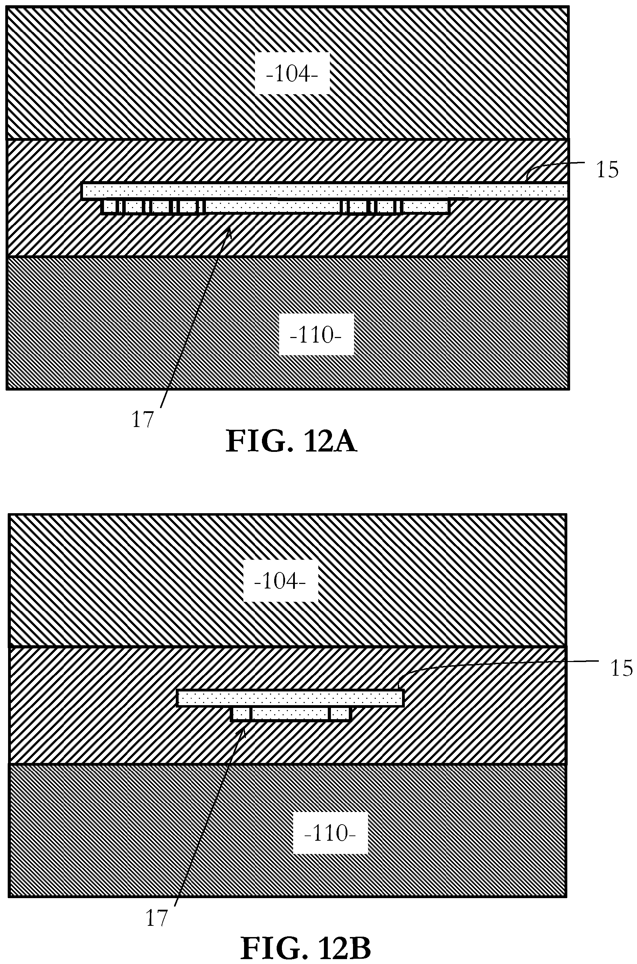

Lors de la prochaine étape (figures 12A et 12B), on retourne l'ensemble de sorte que l'arête 17 est dirigée vers le bas de la figure et le guide en ruban 15 se trouve par-dessus.

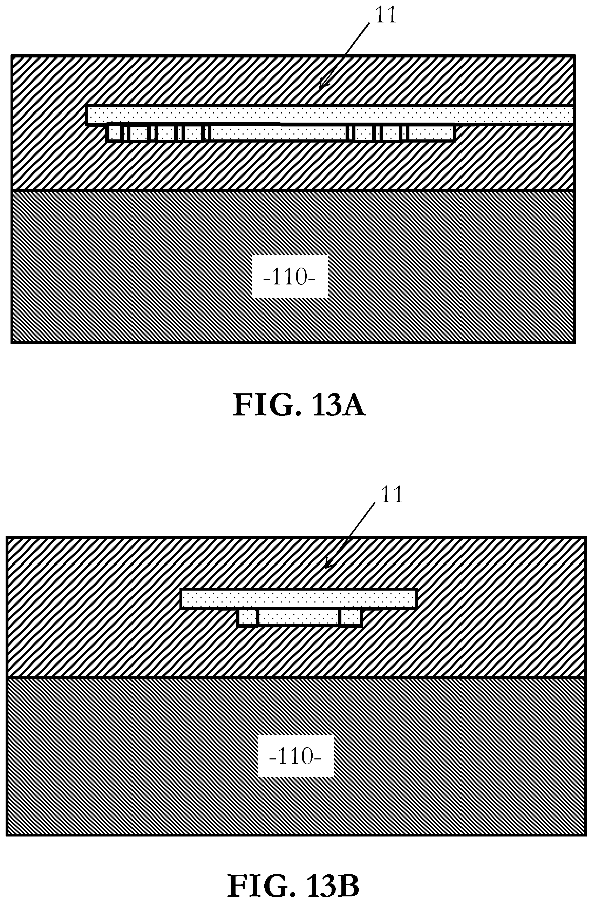

Ensuite, on enlève la couche de substrat de support 104 par exemple par abrasion ou par polissage mécano-chimique (« grinding » en anglais). La couche de BOX 102 (qui peut servir de couche d'arrêt du polissage) se trouve alors en haut complètement découverte (voir figures 13A et 13B).

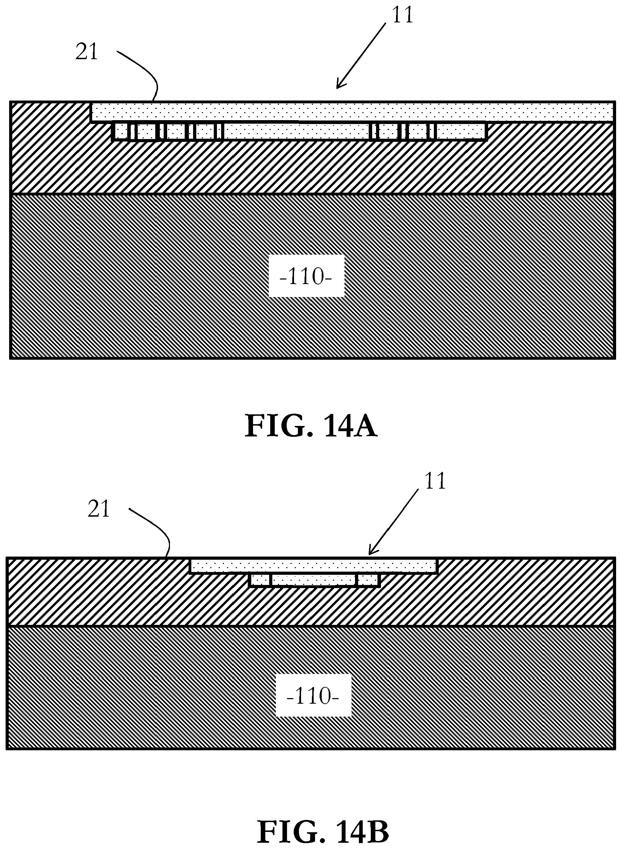

Puis, on retire la couche de BOX 102 par chimie humide sélective ou par gravure sèche par exemple la gravure ionique réactive (« RIE » pour « reactive ion etching » en anglais) ou la gravure plasma couplé par induction (« ICP » pour « inductively coupled plasma » en anglais) de façon à découvrir la face 21 du guide d'onde en ruban 15 qui sera tournée, comme on le verra, vers le milieu amplificateur 3 (voir figures 14A et 14B).

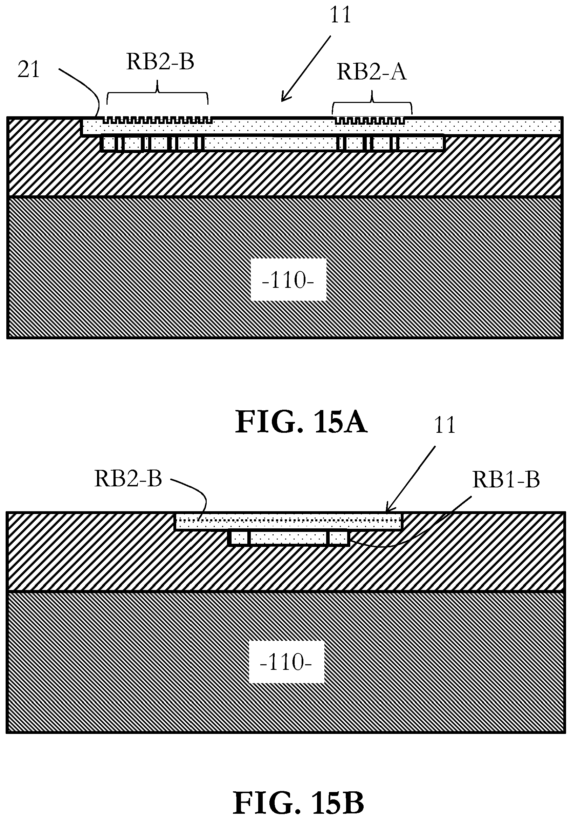

Lors de la prochaine étape (voir figures 15A et 15B), les seconds réseaux de Bragg RB2-A et RB2-B sont gravés (ou structuré) dans la face 21 de la couche de silicium 100 ainsi exposée, de préférence sur toute la largeur du guide en ruban 15.

Selon une variante non représentée, on dépose sur la partie du guide d'onde en ruban une couche supplémentaire de silicium amorphe et les seconds réseaux de Bragg sont gravés (ou structurés) dans cette couche supplémentaire en silicium amorphe. Dans ce cas, l'arête longitudinale 17 est donc en silicium cristallin et le guide d'onde en ruban 15 est formé par deux couches dont celle en contact avec l'arête longitudinale 17 également en silicium cristallin et dont l'autre proximale au milieu amplificateur 3 en silicium amorphe. L'arête longitudinale 17 et la couche en silicium cristallin du guide d'onde en ruban 15 sont dans la couche 13 de silicium sur isolant (SOI).

Ceci permet de garder une compatibilité maximale avec des processus et dispositifs photoniques en silicium existants (par exemple des modulateurs ou photodétecteurs) et de minimiser le budget thermique appliqué à la couche de silicium amorphe.

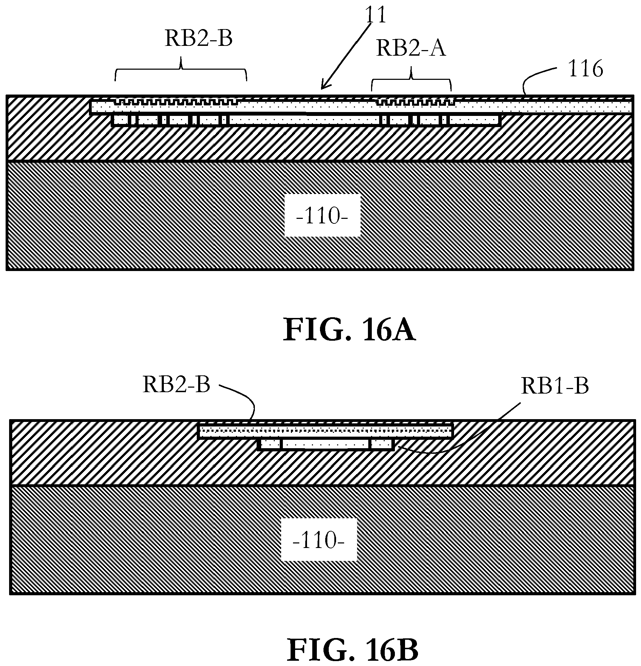

Puis, on dépose, aussi bien dans le cas de la première que de la seconde variante, une couche additionnelle 116 d'isolant, par exemple en SiO₂ d'une centaine de nm sur toute la face ainsi découverte (voir figures 16A et 16B). On peut ensuite soumettre cette couche additionnelle 116 à un polissage mécano-chimique.

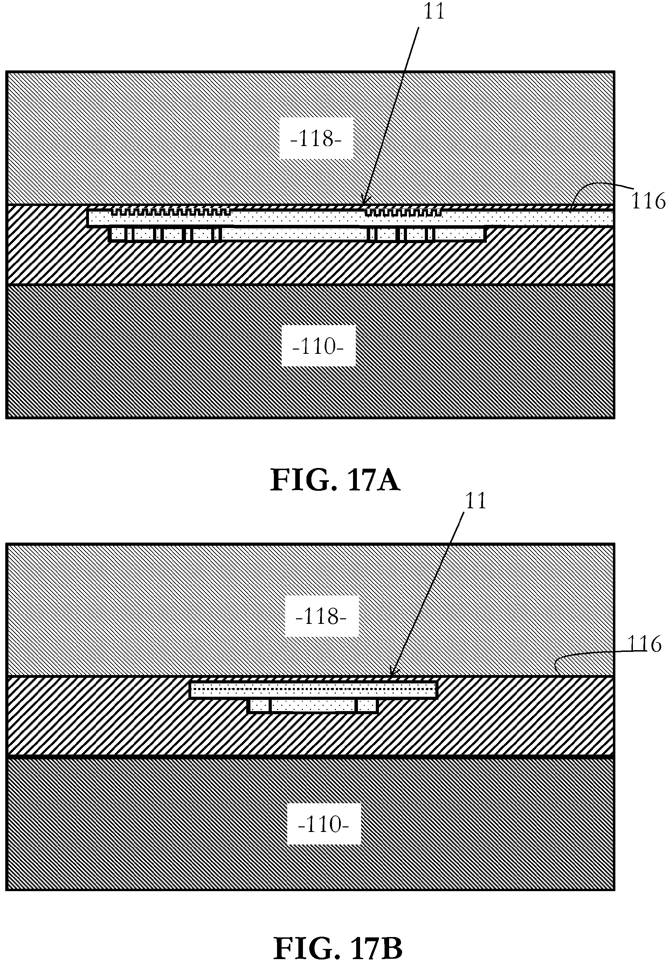

Ensuite, on prend par exemple une plaquette III-V 118 comportant sur une face une hétérostructure III-V. Puis, on colle la plaquette 118, par exemple par collage moléculaire sur la couche additionnelle 116 (voir figures 17A et 17B), de façon que l'hétérostructure se trouve en contact avec la structure réalisée précédemment dans le silicium.

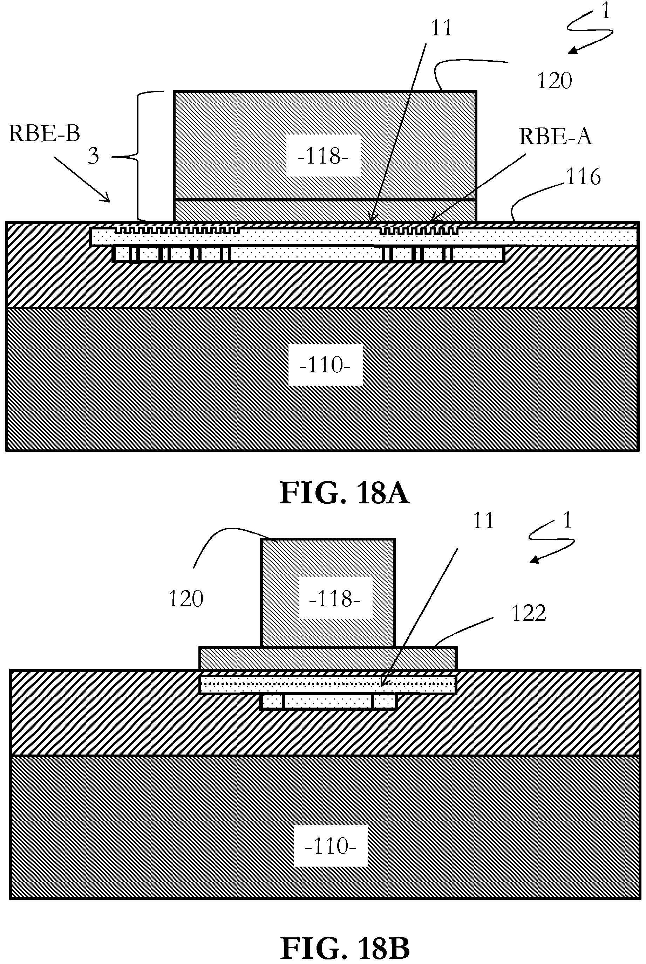

Enfin, on procède à une gravure chimique sélective du substrat de la plaquette collée 118 de façon à obtenir le milieu amplificateur 3 (voir figures 18A et 18B). Par souci de simplification, on n'a pas représenté les couches 9, 5 et 7 du milieu 3.

On peut ensuite procéder à des dépôts eutectiques, par exemple à base d'or, de façon à pouvoir prendre des contacts métalliques sur les couches gravées 120 et 122.

Puis, l'ensemble peut être encapsulé par dépôt d'une autre couche isolante et on peut réaliser de façon classique des contacts métalliques.

On comprend donc que le dispositif laser 1 selon l'invention peut être fabriqué sans difficultés et permet d'avoir une grande liberté dans sa conception pour répondre aux plus grands besoin du marché, notamment de télécommunications.

## Revendications

1. Dispositif laser (1) à hétéro structure III-V intégré sur silicium comprenant
• un milieu amplificateur (3) à hétérostructure III-V, et
• un guide d'onde optique en arête (11), disposé en regard du milieu amplificateur (3) et comprenant un guide d'onde en ruban (15) doté d'une arête longitudinale (17), le guide d'onde optique en arête (11) étant intégré ou formé dans une couche de silicium,
• deux ensembles de réseaux de Bragg (RBE-A, RBE-B) formés dans le guide d'onde optique en arête (11) et disposés de part et d'autre par rapport au milieu amplificateur (3) à hétérostructure III-V,
chaque ensemble de réseaux de Bragg (RBE-A, RBE-B) comprenant un premier réseau de Bragg (RB1-A, RB1-B) présentant un premier pas et formé dans l'arête (17) ainsi qu'un second réseau de Bragg (RB2-A, RB2-B) présentant un second pas différent du premier pas et formé sur la face (21) du guide d'onde en ruban (15) opposée à l'arête (17).

2. Dispositif laser selon la revendication 1, **caractérisé en ce que** le guide d'onde optique en arête (11) est orienté de manière à ce que l'arête (17) soit disposée sur la face (23) du guide d'onde en ruban (15) qui est distale par rapport au milieu amplificateur (3).

3. Dispositif laser selon la revendication 2, **caractérisé en ce que** le premier pas des premiers réseaux de Bragg (RB1-A, RB1-B) formés dans l'arête (17) est plus grand que le second pas du second réseau (RB2-A, RB2-B) formé sur la face (21) du guide d'onde en ruban (15) opposée à l'arête (17).

4. Dispositif laser selon l'une quelconque des revendications 1 à 3, **caractérisé en ce que** l'un (RBE-B) des ensembles de réseaux de Bragg possède une longueur comprise entre 700µm et 1000µm, limites incluses et une réflectivité supérieure à 90% et **en ce que** l'autre ensemble de réseaux de Bragg (RBE-A) possède une longueur comprise entre 300µm et 600µm, limites incluses et une réflectivité comprise entre 30% et 80% limites incluses.

5. Dispositif laser selon l'une quelconque des revendications 1 à 4, **caractérisé en ce que** les premiers réseaux de Bragg (RB1-A, RB1-B) sont formés par des portions rétrécies (24) et des portions plus larges (28) de l'arête (17).

6. Dispositif laser selon la revendication 5, **caractérisé en ce que** la largeur de l'arête (17) au niveau des portions rétrécies (24) est comprise entre 0% - 80% de la largueur des portions plus larges (28) de l'arête (17).

7. Dispositif laser selon la revendication 5 ou 6, **caractérisé en ce que** les seconds réseaux de Bragg (RB2-A, RB2-B) sont uniquement formés au niveau des premiers réseaux de Bragg (RB1-A, RB1-B) à l'emplacement des portions plus larges (28) de l'arête (17).

8. Dispositif laser selon la revendication 5 ou 6, **caractérisé en ce que** les seconds réseaux de Bragg (RB2-A, RB2-B) sont uniquement formés au niveau des premiers réseaux de Bragg (RB1-A, RB1-B) à l'emplacement des portions rétrécies (24) de l'arête (17).

9. Dispositif laser selon l'une quelconque des revendications 5 à 8, **caractérisé en ce que** la transition entre les portions rétrécies (24) et les parties élargies (28) définit des flancs de transition (30) orientés perpendiculairement par rapport à la direction de propagation de la lumière (F1).

10. Dispositif laser selon l'une quelconque des revendications 5 à 8, **caractérisé en ce que** la transition entre les portions rétrécies (24) et les parties élargies (28) définit des flancs de transition (300) qui sont inclinés par rapport à une direction perpendiculaire à la direction de propagation de la lumière (F1).

11. Dispositif laser selon l'une quelconque des revendications 5 à 10, **caractérisé en ce que** la profondeur de gravure des deux réseaux (RB1-A, RB2-A ; RB1-B, RB2-B) d'un ensemble de réseaux de Bragg (RBE-A ; RBE-B) est différente.

12. Dispositif laser selon la revendication 3 et 11 prises ensemble, **caractérisé en ce que** la profondeur de gravure des premiers réseaux (RB1-A, RB1-B) est plus importante que la profondeur de gravure des seconds réseaux (RB2-A, RB2-B).

13. Dispositif laser selon l'une quelconque des revendications 1 à 12, **caractérisé en ce que** la largeur (L_{B}) des seconds réseaux (RB2-A, RB2-B) des ensembles de réseaux de Bragg (RBE-A ; RBE-B) est supérieure à celle de l'arête (17).

14. Dispositif laser selon l'une quelconque des revendications 1 à 13, **caractérisé en ce que** la largueur (L_{B}) des seconds réseaux (RB2-A, RB2-B) des ensembles de réseaux de Bragg (RBE-A ; RBE-B) est sensiblement égale à la largeur du guide d'onde en ruban (15).

15. Dispositif laser selon l'une quelconque des revendications 1 à 14 **caractérisé en ce que** le guide d'onde en ruban (15) et l'arête longitudinale (17) sont chacun formés de silicium cristallin ou l'un en silicium cristallin et l'autre en silicium amorphe.

16. Dispositif laser selon l'une quelconque des revendications 1 à 15, **caractérisé en ce que** l'arête longitudinale (17) est en silicium cristallin et le guide d'onde en ruban (15) est formé par deux couches dont celle en contact avec l'arête longitudinale (17) également en silicium cristallin et dont l'autre proximale au milieu amplificateur (3) en silicium amorphe.

17. Procédé de fabrication d'un dispositif laser selon l'une quelconque des revendications 1 à 16 comprenant les étapes suivantes :
• on réalise un guide d'onde en arête (11) présentant un guide d'onde en ruban doté d'une arête longitudinale dans une couche de silicium (100) disposée au-dessus d'une couche isolante enterrée (102), elle-même disposée au-dessus d'un substrat support (104),
• on réalise par gravure sur l'arête (17) des premiers réseaux (RB1-A, RB1-B) des ensembles de réseaux de Bragg (RBE-A, RBE-B),
• on encapsule par une première couche isolante (110) le guide d'onde en arête (11),
• on retourne l'ensemble,
• on enlève le substrat de support (104) ainsi que la première couche isolante enterrée (102) jusqu'à découvrir une face du guide d'onde en ruban (15),
• on réalise par gravure les seconds réseaux (RB2-A, RB2-B) des ensembles de réseaux de Bragg (RBE-A, RBE-B) dans la face (21) du guide d'onde en ruban (15),
• on dépose une deuxième couche isolante (116) et on réalise un polissage mécano-chimique de la deuxième couche isolante,
• on dépose une hétérostructure (118) formée de matériau semi-conducteur III-V,
• on réalise une gravure chimique sélective de l'hétérostructure (118) pour obtenir un milieu amplificateur (3).

## Patentansprüche

1. Auf Silizium integrierte Laservorrichtung (1) mit III-V-Heterostruktur, umfassend:
• ein Verstärkungsmedium (3) mit III-V-Heterostruktur, und
• einen optischen Kantenwellenleiter (11), der gegenüber dem Verstärkungsmedium (3) angeordnet ist und einen Bandwellenleiter (15) mit einer Längskante (17) umfasst, wobei der optische Kantenwellenleiter (11) in eine Siliziumschicht integriert oder in einer solchen ausgebildet ist,
• zwei Anordnungen von Bragg-Gittern (RBE-A, RBE-B), die in dem optischen Kantenwellenleiter (11) ausgebildet sind und beiderseits des Verstärkungsmediums (3) mit III-V-Heterostruktur angeordnet sind,
wobei jede Anordnung von Bragg-Gittern (RBE-A, RBE-B) ein erstes Bragg-Gitter (RB1-A, RB1-B), das eine erste Schrittweite aufweist und in der Kante (17) ausgebildet ist, sowie ein zweites Bragg-Gitter (RB2-A, RB2-B), das eine zweite Schrittweite aufweist, die von der ersten Schrittweite verschieden ist, und auf der Seite (21) des Bandwellenleiters (15) ausgebildet ist, die der Kante (17) gegenüberliegt, umfasst.

2. Laservorrichtung nach Anspruch 1, **dadurch gekennzeichnet, dass** der optische Kantenwellenleiter (11) so ausgerichtet ist, dass die Kante (17) auf der Seite (23) des Bandwellenleiters (15) angeordnet ist, welche in Bezug auf das Verstärkungsmedium (3) distal ist.

3. Laservorrichtung nach Anspruch 2, **dadurch gekennzeichnet, dass** die erste Schrittweite der ersten Bragg-Gitter (RB1-A, RB1-B), die in der Kante (17) ausgebildet sind, größer als die zweite Schrittweite des zweiten Gitters (RB2-A, RB2-B) ist, das auf der Seite (21) des Bandwellenleiters (15) ausgebildet ist, die der Kante (17) gegenüberliegt.

4. Laservorrichtung nach einem der Ansprüche 1 bis 3, **dadurch gekennzeichnet, dass** die eine (RBE-B) der Anordnungen von Bragg-Gittern eine Länge zwischen 700 µm und 1000 µm, Grenzwerte eingeschlossen, und einen Reflexionsgrad von über 90 % besitzt, und dadurch, dass die andere Anordnung von Bragg-Gittern (RBE-A) eine Länge zwischen 300 µm und 600 µm, Grenzwerte eingeschlossen, und einen Reflexionsgrad zwischen 30 % und 80 %, Grenzwerte eingeschlossen, besitzt.

5. Laservorrichtung nach einem der Ansprüche 1 bis 4, **dadurch gekennzeichnet, dass** die ersten Bragg-Gitter (RB1-A, RB1-B) von verengten Abschnitten (24) und breiteren Abschnitten (28) der Kante (17) gebildet werden.

6. Laservorrichtung nach Anspruch 5, **dadurch gekennzeichnet, dass** die Breite der Kante (17) an den verengten Abschnitten (24) zwischen 0 % und 80 % der Breite der breiteren Abschnitte (28) der Kante (17) beträgt.

7. Laservorrichtung nach Anspruch 5 oder 6, **dadurch gekennzeichnet, dass** die zweiten Bragg-Gitter (RB2-A, RB2-B) ausschließlich an den ersten Bragg-Gittern (RB1-A, RB1-B) am Ort der breiteren Abschnitte (28) der Kante (17) ausgebildet sind.

8. Laservorrichtung nach Anspruch 5 oder 6, **dadurch gekennzeichnet, dass** die zweiten Bragg-Gitter (RB2-A, RB2-B) ausschließlich an den ersten Bragg-Gittern (RB1-A, RB1-B) am Ort der verengten Abschnitte (24) der Kante (17) ausgebildet sind.

9. Laservorrichtung nach einem der Ansprüche 5 bis 8, **dadurch gekennzeichnet, dass** der Übergang zwischen den verengten Abschnitten (24) und den verbreiterten Abschnitten (28) Übergangsflanken (30) definiert, die senkrecht zur Ausbreitungsrichtung des Lichts (F1) ausgerichtet sind.

10. Laservorrichtung nach einem der Ansprüche 5 bis 8, **dadurch gekennzeichnet, dass** der Übergang zwischen den verengten Abschnitten (24) und den verbreiterten Abschnitten (28) Übergangsflanken (300) definiert, welche in Bezug auf eine zur Ausbreitungsrichtung des Lichts (F1) senkrechte Richtung geneigt sind.

11. Laservorrichtung nach einem der Ansprüche 5 bis 10, **dadurch gekennzeichnet, dass** die Ätztiefe der zwei Gitter (RB1-A, RB2-A; RB1-B, RB2-B) einer Anordnung von Bragg-Gittern (RBE-A; RBE-B) unterschiedlich ist.

12. Laservorrichtung nach Anspruch 3 und 11 in Kombination, **dadurch gekennzeichnet, dass** die Ätztiefe der ersten Gitter (RB1-A, RB1-B) größer als die Ätztiefe der zweiten Gitter (RB2-A, RB2-B) ist.

13. Laservorrichtung nach einem der Ansprüche 1 bis 12, **dadurch gekennzeichnet, dass** die Breite (L_{B}) der zweiten Gitter (RB2-A, RB2-B) der Anordnungen von Bragg-Gittern (RBE-A; RBE-B) größer als diejenige der Kante (17) ist.

14. Laservorrichtung nach einem der Ansprüche 1 bis 13, **dadurch gekennzeichnet, dass** die Breite (L_{B}) der zweiten Gitter (RB2-A, RB2-B) der Anordnungen von Bragg-Gittern (RBE-A; RBE-B) im Wesentlichen gleich der Breite des Bandwellenleiters (15) ist.

15. Laservorrichtung nach einem der Ansprüche 1 bis 14, **dadurch gekennzeichnet, dass** der Bandwellenleiter (15) und die Längskante (17) beide aus kristallinem Silizium ausgebildet sind, oder das eine aus kristallinem Silizium und das andere aus amorphem Silizium.

16. Laservorrichtung nach einem der Ansprüche 1 bis 15, **dadurch gekennzeichnet, dass** die Längskante (17) aus kristallinem Silizium besteht und der Bandwellenleiter (15) von zwei Schichten gebildet wird, von denen diejenige, die sich in Kontakt mit der Längskante (17) befindet, ebenfalls aus kristallinem Silizium besteht, und von denen die andere, die proximal zu dem Verstärkungsmedium (3) angeordnet ist, aus amorphem Silizium besteht.

17. Verfahren zur Herstellung einer Laservorrichtung nach einem der Ansprüche 1 bis 16, welches die folgenden Schritte umfasst:
• es wird ein Kantenwellenleiter (11), welcher einen Bandwellenleiter mit einer Längskante aufweist, in einer Siliziumschicht (100) hergestellt, die über einer vergrabenen isolierenden Schicht (102) angeordnet ist, die ihrerseits über einem Trägersubstrat (104) angeordnet ist,
• es werden durch Ätzung auf der Kante (17) erste Gitter (RB1-A, RB1-B) der Anordnungen von Bragg-Gittern (RBE-A, RBE-B) hergestellt,
• der Kantenwellenleiter (11) wird durch eine erste isolierende Schicht (110) gekapselt,
• die Anordnung wird umgedreht,
• das Trägersubstrat (104) sowie die vergrabene erste isolierende Schicht (102) werden entfernt, bis eine Seite des Bandwellenleiters (15) freigelegt ist,
• es werden durch Ätzung zweite Gitter (RB2-A, RB2-B) der Anordnungen von Bragg-Gittern (RBE-A, RBE-B) in der Seite (21) des Bandwellenleiters (15) hergestellt,
• es wird eine zweite isolierende Schicht (116) aufgebracht, und es wird ein chemisch-mechanisches Polieren der zweiten isolierenden Schicht durchgeführt,
• es wird eine Heterostruktur (118) aufgebracht, die aus einem III-V-Halbleitermaterial ausgebildet ist,
• es wird eine selektive chemische Ätzung der Heterostruktur (118) durchgeführt, um ein Verstärkungsmedium (3) zu erhalten.

## Claims

1. Integrated on-silicon III-V heterostructure laser device (1) comprising
• a III-V heterostructure gain medium (3), and
• a rib optical waveguide (11), located facing the gain medium (3) and comprising a strip waveguide (15) doted with a longitudinal rib (17), the rib optical waveguide (11) being integrated into or formed in a silicon layer,
• two sets (RBE-A, RBE-B) of Bragg gratings formed in the rib optical waveguide (11) and located on either side of the III-V heterostructure gain medium (3),
each set (RBE-A, RBE-B) of Bragg gratings comprising a first Bragg grating (RB1-A, RB1-B) having a first pitch and formed in the rib (17) and a second Bragg grating (RB2-A, RB2-B) having a second pitch different from the first pitch and formed on that side (21) of the rib waveguide (15) which is opposite the rib (17).

2. Laser device according to Claim 1, **characterized in that** the rib optical waveguide (11) is oriented so that the rib (17) is located on that side (23) of the strip waveguide (15) which is distal with respect to the gain medium (3).

3. Laser device according to Claim 2, **characterized in that** the first pitch of the first Bragg gratings (RB1-A, RB1-B) formed in the rib (17) is larger than the second pitch of the second grating (RB2-A, RB2-B) formed on that side (21) of the rib waveguide (15) which is opposite the rib (17).

4. Laser device according to any one of Claims 1 to 3, **characterized in that** one (RBE-B) of the sets of Bragg gratings possesses a length comprised between 700 µm and 1000 µm, limits inclusive, and a reflectivity higher than 90%, and **in that** the other (RBE-A) of the sets of Bragg gratings possesses a length comprised between 300 µm and 600 µm, limits inclusive, and a reflectivity comprised between 30% and 80%, limits inclusive.

5. Laser device according to any one of Claims 1 to 4, **characterized in that** the first Bragg gratings (RB1-A, RB1-B) are formed by narrow sections (24) and wider sections (28) of the rib (17).

6. Laser device according to Claim 5, **characterized in that** the width of the rib (17) in the narrow sections (24) is comprised between 0%-80% of the width of the wider sections (28) of the rib (17).

7. Laser device according to Claim 5 or 6, **characterized in that** the second Bragg gratings (RB2-A, RB2-B) are only formed level with the first Bragg gratings (RB1-A, RB1-B) in the location of the wider sections (28) of the rib (17).

8. Laser device according to Claim 5 or 6, **characterized in that** the second Bragg gratings (RB2-A, RB2-B) are only formed level with the first Bragg gratings (RB1-A, RB1-B) in the location of the narrow sections (24) of the rib (17).

9. Laser device according to any one of Claims 5 to 8, **characterized in that** the transition between the narrow sections (24) and the wide sections (28) defines transitional flanks (30) that are oriented perpendicularly to the propagation direction (F1) of the light.

10. Laser device according to any one of Claims 5 to 8, **characterized in that** the transition between the narrow sections (24) and the wide sections (28) defines transitional flanks (300) that are inclined with respect to a direction that is perpendicular to the propagation direction (F1) of the light.

11. Laser device according to any one of Claims 5 to 10, **characterized in that** the etching depth of the two gratings (RB1-A, RB2-A; RB1-B, RB2-B) of a set (RBE-A; RBE-B) of Bragg gratings is different.

12. Laser device according to Claims 3 and 11 taken together, **characterized in that** the etching depth of the first gratings (RB1-A, RB1-B) is larger than the etching depth of the second gratings (RB2-A, RB2-B).

13. Laser device according to any one of Claims 1 to 12, **characterized in that** the width (L_{B}) of the second gratings (RB2-A, RB2-B) of the sets (RBE-A; RB2-B) of Bragg gratings is larger than that of the rib (17).

14. Laser device according to any one of Claims 1 to 13, **characterized in that** the width (L_{B}) of the second gratings (RB2-A, RB2-B) of the sets (RBE-A; RB2-B) of Bragg gratings is substantially equal to the width of the strip waveguide (15).

15. Laser device according to any one of Claims 1 to 14, **characterized in that** the strip waveguide (15) and the longitudinal rib (17) are each formed from crystalline silicon or one is made of crystalline silicon and the other of amorphous silicon.

16. Laser device according to any one of Claims 1 to 15, **characterized in that** the longitudinal rib (17) is made of crystalline silicon and the strip waveguide (15) is formed by two layers, the layer making contact with the longitudinal rib (17) also being made of crystalline silicon and the other layer proximal to the gain medium (3) being made of amorphous silicon.

17. Process for fabricating a laser device according to any one of Claims 1 to 16, comprising the following steps:
• producing a rib waveguide (11) comprising a strip waveguide doted with a longitudinal rib in a silicon layer (100) that is located above a buried insulating layer (102), which itself is located above a carrier substrate (104);
• producing by etching in the rib (11) first gratings (RB1-A, RB1-B) of the sets (RBE-A, RBE-B) of Bragg gratings;
• encapsulating in a first insulating layer (110) the rib waveguide (11);
• flipping the assembly;
• removing the carrier substrate (104) and the first buried insulating layer (102) so as to uncover a side of the strip waveguide (15);
• producing by etching the second gratings (RB2-A, RB2-B) of the sets (RBE-A, RBE-B) of Bragg gratings in the side (21) of the strip waveguide (15);
• depositing a second insulating layer (116) and carrying out chemical-mechanical polishing of the second insulating layer;
• depositing a heterostructure (118) formed from III-V semiconductor; and
• carrying out selective chemical etching of the heterostructure (118) to obtain a gain medium (3).
